Europäisches Patentamt

European Patent Office

Office européen des brevets

(11) Numéro de publication: **0 219 369**
**A1**

## (12) DEMANDE DE BREVET EUROPEEN

(21) Numéro de dépôt: 86401907.0

(22) Date de dépôt: 29.08.86

(51) Int. Cl.⁴: **G 06 K 1/12**
**G 03 F 7/26**

(30) Priorité: 04.09.85 FR 8513113

(43) Date de publication de la demande:
22.04.87 Bulletin 87/17

(84) Etats contractants désignés:
AT BE CH DE FR GB IT LI LU NL SE

(71) Demandeur: **SOCIETE NOUVELLE DE METALLISATION INDUSTRIES SNMI**
Zone Industrielle de St Pierre de Sénos B.P. 205
F-84500 Bollene (FR)

(72) Inventeur: **Gourod, Alain**
**2 rue des Peupliers**
**F-92190 Meudon (FR)**

**Potignon, Jean-Paul**
**3 rue Chantropin**
**F-91530 Saint Cheron (FR)**

(74) Mandataire: **Mongrédien, André et al**
**c/o BREVATOME 25, rue de Ponthieu**
**F-75008 Paris (FR)**

(54) Procédé de marquage d'un objet en métal à l'aide d'un code à barres.

(57) La présente invention a pour objet un procédé de marquage d'un objet à l'aide d'un code à barres.

Pour cela, on dépose une couche (10) d'un matériau ayant l'aspect des barres à obtenir, on réalise un masque sur ce dépôt afin de masquer les endroits correspondant aux barres, on élimine les parties non masquées de la couche (10) et on élimine le masque.

Application au marquage de récipients en acier inoxydable.

FIG. 2

EP 0 219 369 A1

## Description

### PROCEDE DE MARQUAGE D'UN OBJET EN METAL A L'AIDE D'UN CODE A BARRES

La présente invention a pour objet un procédé de marquage d'objets métalliques à l'aide de codes à barres. Ce procédé s'applique en particulier, mais non exclusivement, au marquage de récipients en acier inoxydable destinés à contenir des déchets radioactifs.

Dans certains cas, et notamment afin d'éviter des erreurs, il peut être utile de marquer de tels récipients à l'aide d'un code à barres, ce qui permet de faire lire certaines informations par un rayon laser ou un appareil vidéo et évite les risques d'erreurs qui pourraient se produire si le code était marqué non pas directement sur l'objet, mais sur une pièce rapportée telle qu'une étiquette par exemple.

Pour cela, la présente invention propose un procédé de marquage d'une zone de la surface d'un objet en métal sous forme d'un code à barres, la zone à marquer ayant un premier aspect et les barres un deuxième aspect différent du premier. Les expressions "premier aspect" et "deuxième aspect" désignent les aspects clair ou sombre que peuvent avoir l'objet et les barres. Par exemple, si l'objet est un récipient en acier inoxydable, il a un aspect clair et les barres auront un aspect sombre ou noir. Ces expressions s'appliquent aussi pour désigner des aspects brillant ou mat.

Selon la principale caractéristiques du procédé objet de l'invention, celui-ci comporte les étapes suivantes consistant à :

    (a) - déposer une couche d'un matériau ayant le deuxième aspect sur au moins la zone à marquer;

    (b) - réaliser un masque sur le dépôt afin de masquer les endroits correspondant aux barres ayant le deuxième aspect ;

    (c) - éliminer les parties non masquées de la couche du matériau ayant le deuxième aspect : et

    (d) - éliminer le masque.

Ce procédé s'applique également au marquage d'un objet de petites dimensions pouvant être fixé sur un autre objet de dimensions plus importantes, par exemple une étiquette métallique destinée à être fixée sur un fût de grandes dimensions.

Selon une autre caractéristique du procédé objet de l'invention, le matériau déposé au cours de l'étape (a) est un oxyde et/ou un sulfure du métal constituant l'objet. Ce dépôt peut être effectué par immersion de l'objet dans un bain oxydant et/ou sulfurant.

Selon un autre aspect de l'invention l'étape (b) comporte elle-même les étapes suivantes consistant à:

    (1) - déposer une couche de résine photosensible ;

    (2) - irradier la résine photosensible à travers un masque d'irradiation représentant l'image du code à barres à obtenir ; et

    (3) - développer la résine irradiée.

Dans le cas où la zone à marquer présente un aspect brillant, le procédé comporte une étape supplémentaire, effectuée avant l'étape (a), consistant à dépolir la zone à marquer.

L'invention s'applique plus particulièrement au marquage d'une zone de la surface d'un récipient en acier inoxydable sous forme d'un code à barres noires. Dans ce cas, le procédé comporte les étapes suivantes consistant à :

    (e) - dépolir la zone à marquer ;

    (f) - dépassiver la surface du récipient ;

    (g) - noircir cette surface à l'aide d'un produit de noircissage afin d'obtenir un dépôt noir ;

    (h) - déposer une couche de résine photosensible sur la zone à marquer ;

    (i) - irradier la couche de résine à travers un masque d'irradiation ;

    (j) - développer la couche de résine irradiée ;

    (k) - éliminer le dépôt noir par pulvérisation d'un abrasif;

    (l) - neutraliser la surface du récipient à l'aide d'un produit de neutralisation ; et

    (m) - éliminer les bandes restantes de résine.

Si nécessaire le procédé comporte une étape supplémentaire, effectuée après l'étape (m), consistant à repolir les parties non marquées du récipient. Eventuellement, on peut prévoir encore une autre étape, également effectuée après l'étape (m), qui consiste à inscrire un code en clair sur une partie non marquée de l'objet. Enfin, la résine utilisée au cours des étapes (h) à (j) peut être une résine photosensible positive ou négative.

L'invention apparaîtra mieux à la lecture de la description qui va suivre d'un exemple de mise en oeuvre du procédé objet de l'invention pour le marquage d'un récipient en acier inoxydable, description donnée à titre purement illustratif et nullement limitatif, en référence aux dessins annexés, dans lesquels :

    - la figure 1 est une vue schématique en perspective d'un récipient en acier inoxydable représentant l'aspect de ce récipient une fois marqué,

    - les figures 2a à 2j sont des vues schématiques en coupe illustrant les différentes étapes du procédé objet de l'invention, et

    - la figure 3 est une vue schématique en perspective d'un masque d'irradiation utilisé dans le procédé objet de l'invention.

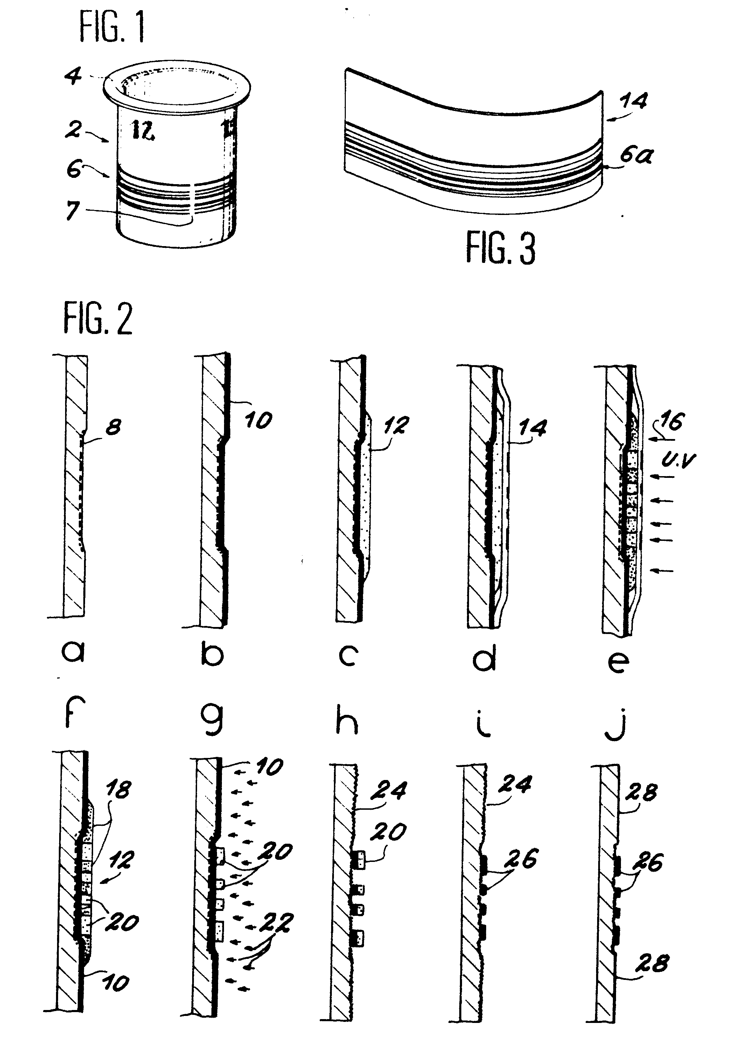

La figure 1 représente un récipient cylindrique ou godet en acier inoxydable portant la référence générale 2. Ce récipient est fermé à sa partie inférieure et ouvert à sa partie supérieure où il présente un rebord 4. Ce récipient comporte un code à barres 6 sur sa partie cylindrique. Les barres sont perpendiculaires aux génératrices du cylindre et se trouvent sur la totalité du pourtour du récipient afin que le code puisse être lu par un rayon laser, quelle que soit la position angulaire du récipient par rapport à l'appareil de lecture. Dans le cas particulier, il s'agit d'un code comportant des barres épaisses et des barres minces destinées à réaliser un code binaire, les barres épaisses ayant la valeur 1 et les barres minces la valeur 0.

On va maintenant décrire en détail les différentes étapes du procédé en référence aux figures 2a à 2j qui sont des vues en coupe de la paroi du récipient dans la région de la zone à marquer.

On voit sur la figure 2a que la première étape consiste à dépolir la zone à marquer 8. Pour cela, il est préférable de réaliser des protections de la surface extérieure du récipient à l'aide d'adhésifs ou de manchons, qui peuvent être en caoutchouc, pour ne laisser apparente que la zone à dépolir, l'intérieur du godet étant protégé par un couvercle d'obturation. Le dépolissage est réalisé par un jet d'abrasif à sec et peut être effectué manuellement dans une cabine à manches. Pour cela, on peut utiliser de la plastite ayant une granulométrie de 115 à 120 mesh, c'est-à-dire de 115 à 120 µm environ, sous une pression de 5 bars. L'intérêt du dépolissage est d'éviter la réflexion des rayons lumineux ou rayons laser destinés à lire le code à barres, ce qui pourrait entraîner un risque d'erreur.

Après l'opération de dépolissage, on pratique un dépoussiérage du récipient et on enlève les protections qui recouvrent les zones non dépolies. On procède ensuite à un traitement de dépassivation de la surface du godet sur la totalité de la surface extérieure de celui-ci. Ce traitement est nécessaire dans le cas de l'acier inoxydable afin d'obtenir un dégrais sage et un nettoyage complets du matériau avant de passer aux étapes suivantes. Ce traitement de dépassivation est réalisé par immersion dans un bain d'acide nitrique à 50% de concentration maintenu à une température de 60°C pendant 30 minutes.

Une fois que la surface du récipient est dépassivée, on passe à l'étape suivante qui est le noircissement de l'ensemble de la surface extérieure. Cette opération est réalisée par immersion dans un bain d'un produit noircissant. Pour cela on peut utiliser par exemple de l'EBONOL SS 48. Il s'agit d'un produit de noircissage alcalin donnant un dépôt noir d'oxyde et de sulfure de fer sur de l'acier inoxydable. Par une immersion de 5 à 15 minutes dans ce produit maintenu à une température de 127°C en étuve, on obtient un dépôt noir 10 (figure 2b) d'oxyde et de sulfure de fer ayant une épaisseur de 1,2 à 2,5 microns. Une fois ce dépôt effectué, on laisse refroidir le récipient et on le soumet à un rinçage abondant à l'eau courante pendant 10 minutes environ, puis on le sèche en étuve. Pour cela, le récipient est monté et mis en rotation sur un système mécanique approprié dans une enceinte équipée d'un soufflage d'air chaud permettant d'obtenir une température constante de 100°C.

L'étape suivante, illustrée à la figure 2c, consiste à appliquer une couche 12 de résine photosensible sur la zone à marquer. Pour cela, on peut utiliser un film photopolymère de type RISTON commercialisé par la Société Dupont de Nemours. La couche de résine est appliquée à l'aide d'un rouleau en caoutchouc afin d'exercer une certaine pression et d'éviter une éventuelle inclusion de bulles d'air entre le film et la paroi métallique à graver. Sur la figure 2c, la couche de résine 12 ne se trouve que sur la zone à marquer, mais on ne sortirait pas du cadre de l'invention en utilisant, pour des raisons de commodité éventuelles, une couche couvrant une surface plus vaste de l'objet.

On place ensuite, par dessus la couche de résine 12, un masque d'irradiation 14 (figure 2d). Dans le cas particulier décrit ici, il s'agit d'un film photographique rectangulaire ayant une longueur égale à la circonférence de la partie cylindrique du récipient 2 et une largeur égale à la distance séparant le rebord supérieur 4 de ce récipient de la partie inférieure du code 6. Cette disposition est utilisée pour des raisons de commodité, le masque 14 étant placé et centré à partir du rebord 4. On voit sur la figure 3 que le masque 14 comporte lui-même un code à barres 6a qui est la reproduction exacte du code à obtenir sur le récipient : l'emplacement du marquage 6a sur le masque 14 est tel qu'il se trouve exactement sur la zone à marquer lorsque le bord supérieur du masque 14 est en contact avec la face inférieure du rebord 4. Il n'est pas nécessaire que la longueur du masque 14 soit exactement égale à la circonférence du récipient 12. En effet, on peut tolérer un léger espace, comme cela est représenté en 7 sur la figure 1 : si cet espace est suffisamment étroit (par exemple de largeur inférieure à 1 mm), cela ne gêne pas la lecture par un appareil vidéo ou un rayon laser.

Afin d'obtenir une grande précision, on peut réaliser le dessin du code à barres sur le masque 14 à l'aide d'un coordinatographe, ce qui permet d'assurer une précision inférieure ou égale un centième de millimètre. On peut utiliser pour cela un film pelliculable "ART GRAPHIC", celui-ci étant traité photographiquement et développé par traitement "LITH" afin d'obtenir un film sans relief, ce qui évite le dégradé en bordure des barres.

Bien entendu, il n'est pas nécessaire de réaliser un masque tel que le masque 14 pour chaque opération de marquage. En effet, celui-ci peut être utilisé plusieurs fois et il suffit d'avoir autant de masques que de codes différents à inscrire. D'autre part on ne sortirait pas du cadre de l'invention en utilisant une autre méthode pour réaliser le masque, l'essentiel étant d'obtenir un objet transparent sur lequel figure le dessin du code à obtenir. Enfin, on ne sortirait pas non plus du cadre de l'invention en modifiant la forme et les dimensions du masque ou le mode de fixation de celui-ci pourvu que le dessin 6a du code se trouve en position correcte par rapport à la zone à marquer.

Une fois que le masque 14 est en place par dessus la couche de résine 12, on irradie cette dernière à travers le masque grâce à un rayonnement ultraviolet symbolisé sur la figure 2e par les flèches 16. Comme le code 6a inscrit sur le masque 14 est constitué d'un ensemble de barres noires, ces dernières arrêtent les ultraviolets à certains endroits. ce qui a pour effet que certaines zones de la résine sont irradiées et d'autres non. L'adjectif "transparent" utilisé dans la présente description à propos du masque 14 signifie que celui-ci doit laisser passer le rayonnement utilisé pour irradier la résine et pas nécessairement qu'il doit être transparent à la lumière visible.

Avec des récipients ayant un diamètre et une hauteur de l'ordre de 100 à 200 mm, on effectue une rotation d'un quart de tour toutes les 30 secondes. avec une durée d'exposition totale de 2 minutes. Bien entendu, il ne s'agit là que d'un exemple et on peut faire varier la durée d'exposition et le nombre de déplacements en fonction des dimensions de l'objet à marquer. En particulier, une rotation peut ne pas être utile si l'on ne désire marquer qu'une partie de la surface de l'objet. Eventuellement, la rotation peut être continue, ou on peut maintenir l'objet fixe et faire tourner la source d'irradiation.

On retire ensuite le masque 14 et l'on arrive à la situation de la figure 2f où l'on voit que la couche 12 de résine comporte des zones irradiées 18 et des zones non irradiées 20. L'étape suivante consiste à développer la couche de résine, par exemple par immersion dans un bain de trichloréthane chaud, la durée de développement ainsi que la température du bain étant fonction de la résine utilisée.

On procède ensuite à un rinçage abondant à l'eau courante sous pression, suivi d'un étuvage à l'air chaud pendant 1 heure à la température de 80°C. On obtient ainsi ce qui est représenté à la figure 2g : le récipient est toujours recouvert du dépôt noir 10, mais il ne reste plus que les parties 20 de la résine qui n'ont pas été irradiées. Ces parties 20 se présentent sous forme de bandes annulaires entourant le récipient.

Dans l'exemple décrit ici, on utilise une résine photosensible positive, c'est-à-dire que les parties irradiées sont éliminées au développement. Mais on ne sortirait pas du cadre de l'invention en utilisant une résine négative, c'est-à-dire dans laquelle ce sont les parties non irradiées qui son éliminées au développement. Dans ce cas, il faut modifier le masque 14 afin que ce soit des parties transparentes de celui-ci qui correspondent aux barres à obtenir sur l'objet. On procède ensuite à l'élimination du dépôt 10 par pulvérisation à l'aide d'un abrasif, par exemple du chlorure ferrique. Pour cela, le récipient est monté et mis en rotation sur une machine de pulvérisation de chlorure ferrique. Les jets de pulvérisation, symbolisés par les flèches 22, projettent le produit sous une pression de 2 bars. Dans le cas particulier décrit ici, le temps d'attaque est d'environ 10 minutes et on obtient une gravure comprise en 0,10 et 0,14 mm. On procède ensuite à un rinçage prolongé l'eau courante suivi d'une neutralisation par immersion dans un bain à 5% de carbonate de soude à température ambiante. Cette neutralisation a pour but d'éviter des réactions parasites ultérieurement. On effectue ensuite un second rinçage à l'eau courante.

On a ainsi éliminé le dépôt noir sur la totalité de la surface du récipient, sauf aux endroits où celui-ci est protégé par les parties 20 non irradiées de la résine, comme cela est illustré à la figure 2h. On retire ces bandes 20 en plongeant le récipient dans un bain de chlorure de méthylène pur, puis en le soumettant à un traitement par ultrasons afin d'éliminer toute trace de résine. On procède ensuite à un séchage en phase vapeur, puis à un dernier rinçage à l'eau courante suivi d'un séchage en étuve pendant 1 heure à la température de 80°C. On arrive ainsi à la situation de la figure 2i où il ne reste plus que les bandes noires 26 qui constituent le code 6 illustré à la figure 1.

Les figures 2h et 2i montrent que le traitement de pulvérisation destiné à éliminer le dépôt noir a plus ou moins abimé la surface de la pièce, comme cela est indiqué en 24 sur ces figures. D'autre part. il se peut que du matériau de noircissage reste encore à certains endroits. C'est pourquoi, si cela s'avère nécessaire, on effectue un polissage des parties non marquées du récipient afin de retrouver l'aspect initial poli et brillant, comme cela est indiqué en 28 sur la figure 2j.

Eventuellement. une fois le récipient marqué à l'aide des barres, on peut prévoir une étape supplémentaire consistant à graver un code en clair sur les parties non marquées du récipient. On voit sur la figure 1 que ce code consiste en un nombre (ici le nombre 12) qui peut être reproduit plusieurs fois sur la périphérie, par exemple à trois endroits décalés de 120° les uns des autres, à la partie supérieure du récipient.

Pour cela, on peut utiliser un cache en acier inoxydable de 0,3 mm d'épaisseur ayant la forme d'un cylindre dont le diamètre intérieur correspond sensiblement au diamètre extérieur du récipient 2. Ce cache comporte un certain nombre de découpes représentant chacune le code à graver, le nombre de découpes étant égal au nombre de fois où le code en clair doit être marqué sur le récipeint. Ces découpes peuvent être effectuées par un procédé chimique. Le cache peut être maintenu par un système à pinces sur le rebord 14 du récipient 2 afin d'obtenir un positionnement correct. Une fois ce montage effectué, on protège le récipient 2 par un manchon qui ne laisse apparaître que le cache tandis que l'ouverture supérieure du récipient est fermée à l'aide d'un obturateur. Le marquage du code se fait à l'aide d'un jet d'abrasif, ce qui permet d'obtenir des chiffres mats sur fond brillant. On réalise ensuite un dépoussiérage sous un jet d'air comprimé ainsi qu'un dégraissage. Puis, on retire le manchon de protection, on démonte le cache et on retire l'obturateur qui fermait le récipient.

Le procédé objet de l'invention présente des avantages particulièrement intéressants dont le principal est d'obtenir un marquage précis qui adhère bien à l'objet. Le procédé décrit ici a été utilisé pour le marquage de récipients en acier inoxydable Z2 CN 18/10 ayant un diamètre extérieur de 150 mm et une hauteur de 167,5 mm. Les barres minces (valeur 0) devaient avoir une largeur de 1 mm, et en tout cas pas inférieure à 0,6 mm, et les barres épaisses (valeur 1) une largeur de 2 mm, et en tout cas pas inférieure à 1,2 mm. Les intervalles entre deux barres consécutives devaient avoir une largeur de 1 mm et en tout cas pas inférieure à 0,6 mm. Le rapport des largeurs entre les barres épaisses et les barres minces devait être égal à 2 et en tout cas rester inférieur à 2,5 afin de permettre un décodage par des méthodes vidéo ou laser. Le procédé de l'invention a permis d'obtenir des cotes très proches des dimensions indiquées ci-dessus.

D'autre part. ce procédé évite des surépaisseurs à l'endroit du marquage et il peut être mis en oeuvre quelle que soit la géométrie de l'objet.

Enfin. l'invention ne se limite pas au seul mode de réalisation qui vient d'être décrit, mais on peut envisager de nombreuses variantes sans sortir pour autant du cadre de l'invention. C'est ainsi que l'homme du métier pourra faire varier les conditions de mise en oeuvre du procédé suivant la nature et la forme de l'objet à marquer et/ou suivant la forme du code à inscrire

Par exemple, le dépolissage peut être réalisé sur une surface plus vaste que la zone à marquer, si cela s'avère plus commode, ou, si l'objet est mat, le dépolissage n'est pas nécessaire. D'autre part, le produit noircissant, ainsi que la manière de le déposer, seront choisis en fonction de la nature de l'objet à marquer. Quant aux étapes intermédiaires telles que rinçage, séchage, neutralisation, etc..., on pourra les modifier, ou éventuellement les supprimer, en fonction de chaque cas particulier. Enfin, si on a décrit un exemple dans lequel l'objet à marquer a un aspect clair et les barres un aspect sombre, l'invention s'applique tout aussi bien au marquage d'un objet sombre avec des barres claires.

D'autre part, si l'exemple décrit ci-dessus concerne un récipient en acier inoxydable dont les dimensions sont de l'ordre du décimètre, le procédé objet de l'invention s'applique à n'importe quel objet métallique, de forme et de dimensions quelconques, par exemple des fûts de grandes dimensions (de l'ordre du mètre), des nacelles ou des étiquettes métalliques destinées à être fixées sur d'autres objets.

**Revendications**

1. Procédé de marquage d'une zone (8) de la surface d'un objet en métal (2) sous forme d'un code à barres (6), la zone à marquer (8) ayant un premier aspect et les barres un deuxième aspect différent du premier, caractérisé en ce qu'il comporte les étapes suivantes consistant à :

(a) - déposer une couche (10) d'un matériau ayant le deuxième aspect sur au moins la zone à marquer (8) ;

(b) - réaliser un masque sur le dépôt (10) afin de masquer les endroits correspondant aux barres ayant le deuxième aspect ;

(c) - éliminer les parties non masquées de la couche (10) de matériau ayant le deuxième aspect; et

(d) - éliminer le masque.

2. Procédé selon la revendication 1, caractérisé en ce que la zone à marquer (8) a un aspect clair et les barres un aspect sombre.

3. Procédé selon l'une quelconque des revendications 1 et 2, caractérisé en ce que le matériau déposé au cours de l'étape (a) est un oxyde et/ou un sulfure du métal constituant l'objet (2).

4. Procédé selon la revendication 3, caractérisé en ce qu'on réalise l'étape (a) par immersion de l'objet (2) dans un bain oxydant et/ou sulfurant.

5. Procédé selon l'une quelconque des revendications 1 à 4, caractérisé en ce que l'étape (b) comporte les étapes suivantes consistant à :

(1) - déposer une couche (12) de résine photosensible;

(2) - irradier la résine photosensible à travers un masque d'irradiation (14) représentant l'image (6a) du code à barres à obtenir ; et

(3) - développer la résine irradiée.

6. Procédé selon l'une quelconque des revendications 1 à 5, caractérisé en ce que la zone à marquer (8) ayant un aspect brillant, il comporte une étape supplémentaire, effectuée avant l'étape (a), consistant à dépolir la zone à marquer (8).

7. Procédé de marquage d'une zone (8) de la surface d'un récipient (2) en acier inoxydable sous forme d'un code à barres noires (6), caractérisé en ce qu'il comporte les étapes suivantes consistant à :

(e) - dépolir la zone à marquer (8) ;

(f) - dépassiver la surface du récipient (2) ;

(g) - noircir cette surface à l'aide d'un produit de noircissage, afin d'obtenir un dépôt noir (10);

(h) - déposer une couche (12) de résine photosensible positive sur la zone à marquer (8) ;

(i) - irradier la couche (12) de résine à travers un masque d'irradiation (14) ;

(j) - développer la couche de résine irradiée ;

(k) - éliminer le dépôt noir (10) par pulvérisation d'un abrasif;

(l) - neutraliser la surface du récipient à l'aide d'un produit de neutralisation ; et

(m) - éliminer les bandes restantes (20) de résine.

8. Procédé selon la revendication 7, caractérisé en ce qu'il comporte une étape supplémentaire, effectuée après l'étape (m), consistant à repolir les parties non marquées du récipient (2).

9. Procédé selon l'une quelconque des revendications 7 et 8, caractérisé en ce qu'il comporte une étape supplémentaire, effectuée après l'étape (m), consistant à inscrire un code en clair sur une partie non marquée de l'objet (2).

0219369

FIG. 1

FIG. 3

FIG. 2

a   b   c   d   e

f   g   h   i   j

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| Y | US-A-3 792 238 (C.E.A.)<br><br>* Figures 1,2; colonne 2, ligne 62 - colonne 4, ligne 6 * | 1,2,5, 7 | G 06 K 1/12<br>G 03 F 7/26 |
| Y | US-A-4 119 480 (TOKYO SHIBAURA)<br><br>* Figures 1-5; colonne 2, ligne 60 - colonne 5, ligne 14 * | 1,2,5, 7 | |
| Y | KODAK PUBLICATION, no. P-79, 1970, pages 1-28, Eastman Kodak Co., Rochester, US; "An introduction to photofabrication using Kodak photosensitive resists"<br>* Pages 2-6; page 13, colonne de droite, paragraphe "Surface preparation"; page 14, colonne de gauche * | 1,2,5, 7 | |
| A | FR-A-2 254 255 (SOCIETE POUR L'UTILISATION RATIONNELLE DES GAZ)<br>* Figures 1,2; page 2, ligne 37 - page 4, ligne 34 * | 1 | **DOMAINES TECHNIQUES RECHERCHES (Int. Cl.4)**<br><br>G 06 K<br>G 03 F<br>G 09 F |

Le présent rapport de recherche a été établi pour toutes les revendications

| Lieu de la recherche | Date d'achèvement de la recherche | Examinateur |
|---|---|---|
| LA HAYE | 11-12-1986 | FORLEN G.A. |